(19) Europäisches Patentamt
European Patent Office
Office européen des brevets

(11) **EP 1 955 088 B1**

## (12) EUROPEAN PATENT SPECIFICATION

(45) Date of publication and mention
of the grant of the patent:
**19.10.2016 Bulletin 2016/42**

(51) Int Cl.:
***G01R 35/04*** (2006.01)     ***G01D 18/00*** (2006.01)
***G01D 4/08*** (2006.01)     ***G01R 11/17*** (2006.01)
***G01R 22/06*** (2006.01)

(21) Application number: **06820098.9**

(22) Date of filing: **27.11.2006**

(86) International application number:
**PCT/FI2006/050518**

(87) International publication number:
**WO 2007/063180 (07.06.2007 Gazette 2007/23)**

(54) **METHOD AND SYSTEM FOR THE CALIBRATION OF METERS**

VERFAHREN UND SYSTEM ZUR KALIBRATION VON ZÄHLERN

PROCÉDÉ ET SYSTÈME D'ÉTALONNAGE DE COMPTEURS

(84) Designated Contracting States:
**AT BE BG CH CY CZ DE DK EE ES FI FR GB GR
HU IE IS IT LI LT LU LV MC NL PL PT RO SE SI
SK TR**

(30) Priority: **01.12.2005 FI 20051233**

(43) Date of publication of application:
**13.08.2008 Bulletin 2008/33**

(73) Proprietor: **Teknologian tutkimuskeskus VTT Oy
02150 Espoo (FI)**

(72) Inventor: **SEPPÄ, Heikki
FI-00370 Helsinki (FI)**

(74) Representative: **Seppo Laine Oy
Itämerenkatu 3 B
00180 Helsinki (FI)**

(56) References cited:
**CN-A- 1 182 879**     **CN-A- 1 621 853**
**DE-A1- 3 743 064**     **DE-A1- 3 743 064**
**JP-A- 06 273 200**     **US-A1- 2002 049 549**
**US-A1- 2002 049 549**     **US-B1- 6 311 105**

**Description**

The present invention relates to a calibration method according to Claim 1.

The invention also relates to a system for the calibration of meters.

In energy measurement, there is a significant increase in remote reading. Particularly in Sweden and the other Nordic countries there is great pressure in this direction. In China too, where there is an enormous lack of energy, there is pressure to change to remote reading. As remotely-read meters become common, it is very probable that the quality of the energy too will be monitored meter-specifically. This is because the plain remote reading and the increase in efficiency it brings may not necessarily be enough to cover the costs incurred by power companies due to remote reading. In locations in which there are several meters, it is natural that the consumption of the meters is read first of all from the most accurate meter and that this meter forwards the data to the power company. The sufficient accuracy of meters is important for both the consumers and the power companies. Legislation on the gauging of meters varies greatly from one country to another. All countries, however, require some method of determining the accuracy of meters. Often all meters that have reached a certain age are collected for inspection and after servicing are returned to the field or are replaced by new meters. By sampling, the stock of poor meters can be identified, but the method does not ensure the accuracy of all meters.

A drawback of the prior art is that random inspection methods are not accurate and meters that clearly give an erroneous reading can remain undetected. Replacing old meters too late with new ones leads to a significant increase in error while, on the other hand, a similar operation that takes place too early will significantly increase costs.

DE3743064 A1 discloses a method for calibrating meters in a system wherein the measurement error of individual meters is corrected by a calculated quotient.

The invention is intended to eliminate the defects of the prior art disclosed above and for this purpose create an entirely new type of method for calibrating meters, particularly energy-consumption meters.

The invention is based on using a single more accurate meter to measure the sum quantity of simple meters and by using a repeated and at least approximately simultaneous measurement of all the meters to produce statistical information on the individual measurement result of each meter relative to the measurement result of the summing meter. Faulty meters are detected on the basis of the statistical properties of the measurement results.

In one preferred embodiments of the invention the consumption of electrical energy is measured.

More specifically, the method according to the invention is defined by the features of Claim 1.

The system according to the invention is, in turn, defined by the features of Claim 8. Considerable advantages are gained with the aid of the invention.

With the aid of the method according to the invention, the inaccuracy of meters networked around a remotely-readable meter can be measured without disconnecting the meters from the network. Only a fraction of the number of expensive precision meters presently required are needed, because only the summing meters need to be precision meters. Because the price of a kilowatt-hour meter is about € 30 and the present price of a single meter readable remotely using GSM is about € 100, the disconnection and calibration and reinstallation of a meter is a very significant additional cost. In the future, the relative cost of meters will diminish, but the cost of the calibration process using traditional calibration methods will probably increase. Thus introducing automatic calibration according to the invention to an electricity network will be a very important measure in saving costs.

If RFID-reading using a mobile telephone is added to existing meters, it will be possible to utilize the method disclosed in the present invention in their calibration too.

In the following, the invention is examined with the aid of examples and with reference to the accompanying drawing.

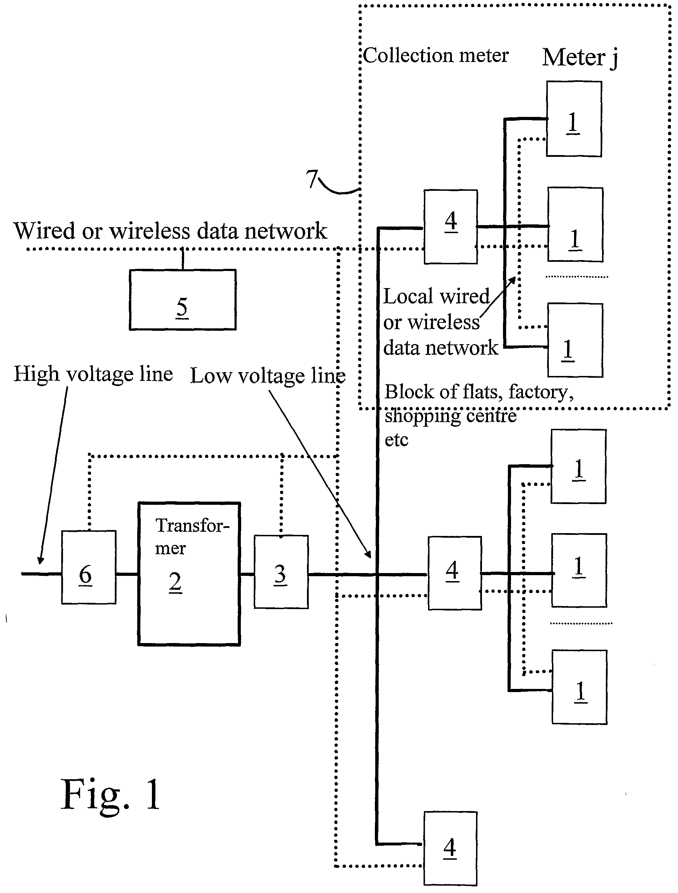

Figure 1 shows a block diagram of one system suitable for the method according to the invention.

Figure 1 shows schematically a system, in which the $K$ meter 1 is connected to, for example, a 'collection meter' 4 in a block of flats, which is connected by a wire or wirelessly to a data network 7. The collection meter 4, or j individual meters 1 are also connected over the data network 7 to remotely-readable meters 3 and 5 in the vicinity of a transformer station 2. In our estimate, we assume that the collection meters 4 are of a precision class that is clearly more accurate than that of the meters 1 in the network behind it. In this application, the meters 1 are also referred to as field meters. The measurement results read from the meters are transmitted with the aid of the data network to a server 5 for calculation operations.

First of all, a simple case is examined, in which $j$ meters 1 are connected to, for example, a collection meter 4 in a block of flats. In addition, it is assumed that measurement data is collected into a memory at regular intervals. Now we can write an equation relating to a moment or period of time $i$.

$$P_\Sigma(i) = \sum_j (1 + \varepsilon_j) P_j(i) + P_{j,0}$$

In the equation, $\varepsilon_j$ depicts a slowly time-dependent systematic error in an individual *meter j* (1) and $P_{j,0}$ its zero-point error. Here it is assumed that the collection meter 4 is accurate, or that the error relating to it is known. Once we have made *N* measurements, we can write the following matrix equation on the basis of the results

$$\begin{bmatrix} P_\Sigma(1) \\ P_\Sigma(2) \\ .. \\ P_\Sigma(N) \end{bmatrix} = \begin{bmatrix} P_1(1) & P_1(2) & .. & P_1(N) \\ P_2(1) & P_2(2) & .. & P_2(N) \\ .. & .. & .. & .. \\ P_K(1) & P_K(2) & .. & P_K(N) \end{bmatrix} \begin{bmatrix} \varepsilon_1 + 1 \\ \varepsilon_2 + 1 \\ .. \\ \varepsilon_K + 1 \end{bmatrix} + \begin{bmatrix} P_{1,0} \\ P_{2,0} \\ .. \\ P_{K,0} \end{bmatrix}$$

If we assume that the measurements are made sufficiently often, we can assume that the results of an individual user will not correlate completely with the results of another meter. In addition, we assume that the use of power by each user varies over time. This means mathematically that the determinant of the power matrix of the above equation deviates from zero. We assume first, that there is no zero-point error in the meters 1. We can now solve the equation for the relative inaccuracy of each individual meter 1 (*j* in the equation)

$$\begin{bmatrix} \varepsilon_1 \\ \varepsilon_2 \\ .. \\ \varepsilon_K \end{bmatrix} = \begin{bmatrix} P_1(1) & P_1(2) & .. & P_1(N) \\ P_2(1) & P_2(2) & .. & P_2(N) \\ .. & .. & .. & .. \\ P_K(1) & P_K(2) & .. & P_K(N) \end{bmatrix}^{-1} \begin{bmatrix} P_\Sigma(1) \\ P_\Sigma(2) \\ .. \\ P_\Sigma(N) \end{bmatrix} - \begin{bmatrix} 1 \\ 1 \\ .. \\ 1 \end{bmatrix}$$

In addition, we can solve the error deviation on the basis of the measurement results. The uncertainty of the inaccuracy depends on the deviation of the use of power at the various meters 1 and on the measurement deviation of both the individual meters 1 and the collection meter 4. The essential point, however, is that over time all the meters (1) through which power passes will become calibrated. The solution described here requires the inverse operation of the matrix, which demands a great deal of processor power. In addition, the calculation of the inaccuracy of the error requires the inverse operation of the matrix. However, the inversion of the matrix can be eliminated by using so-called recursive methods, in which, on the basis of each new measurement result, the value of the error vector is corrected. The use of a recursive method permits the processor of the collector meter 4 to estimate the error using its own processor. This significantly reduces the need to transfer data between the meters and the server 5. In factories, shopping centres, and blocks of flats, it is worthwhile measuring the reading of each meter at intervals of 1 s - 10 s by using a local data network 7, and the collection meter 4 estimates the inaccuracies of the meters on the basis of the results. This information can be attached to form part of the 'quality information' and be sent to the power company when necessary, for example, at intervals of 1 h - 1 month. It is also possible to operate in such a way that information on a possibly faulty meter and on the magnitude of the error is sent only if the error is sufficiently large and its uncertainty smaller than the error. In a situation, in which remotely-read data are transferred directly from an individual meter to the power company, it will be necessary to make the calculation in a central computer and the remotely-read results should be obtained at as close intervals as possible, thus allowing the inaccuracy of the meter to be solved on the basis of the results. A suitable interval of time in such a situation is 1 - 10 minutes. The less frequently a meter is read, the longer the estimation of the inaccuracy of the meters will take. Fortunately, however, a large error will be revealed very quickly and thus non-functioning meters will be detected rapidly.

By collecting hour data from all the meters, both in a low-voltage network and high-voltage networks, the method makes possible a situation, in which in principle only one meter measuring the energy of the network under the entire power company has to be calibrated. If these meters that measure very large amounts of power are replaced, for example, with three meters, it will also be possible on the basis of remote reading to monitor whether any of these meters may have developed a fault. By introducing remote reading in the entire network and applying the method described above, a power company could almost entirely automate the monitoring of the reliability of the meters.

Thus, with reference to Figure 1, the calibration method of the meters 1 can, with the aid of the meter 4, be applied in a corresponding manner to the meters 4, with the aid of a higher-level collection meter 5.

Generally, by calculating deviation we will notice that the uncertainty of the inaccuracy of meters, through which only a small amount of power travels, remains large while on the contrary the meters, which measure large energy readings become more accurately calibrated. If power is taken from the network by bypassing a meter, the model leads us to understand that the inaccuracy of some meter has changed rapidly. If, however, the inaccuracy of the meter is typically a very slow function of time, it is probable that in such a case power is being taken from the network by bypassing a meter, or that there is a leak in the network. In other words, by monitoring the development over time of the inaccuracy of meters, it is possible to deduce the condition of the network, or the possible misuse of the electricity network. In addition, if it happens that the error in all the meters in some sub-network is the same, it is possible to suspect that the reason lies in the erroneous reading of the collection meter, and not in the meters in the network. Of course, the inaccuracy of the collection meter can be estimated with the aid of the meters that are on the high-voltage side of the network.

The method does not state whether the power company is entitled to correct the reading of a meter on the basis of the error data, or whether it must replace the faulty meter. In principle, it would be possible for the correction of the reading of the meter to be permitted up to some limit, so that meters need not be replaced at all due to an erroneous reading. Of course, if the inaccuracy of a meter is due to non-linearity, the reading of the meter cannot be corrected.

We have depicted a simple method for monitoring the error of kilowatt-hour meters in remotely-read networks. The introduction of the method will bring significant savings to power companies. In addition, the method permits the monitoring of both the condition of the network and of possible misuse. Even though in the examples we dealt with a single-phase case, the method can naturally also be used in three-phase networks. If, for example, in a block of flats the three-phase network is connected through a three-phase summing meter to single-phase meters, the advantages of the method are even accentuated. This is because only a reasonable number of meters will come after a single phase and thus an error in the meters will be detected more quickly. The method can naturally also be used in district-heating meters, but a change in the power losses of the network and changes in temperature may interfere with the use of the method. The method can also be exploited in flow meters in factories, gas fields, etc.

The calibration calculations are made using some suitable computer 5, which is preferably connected directly as the calculation server of the data network 7. The measurement results can, of course, be transferred for calculation to the computer 5 in other ways than with the aid of a data network 7, for example, with the aid of a suitable memory medium, such as a removable hard disk or some other similar memory medium.

As has become apparent from the above example, one typical measurable quantity is the consumption of electrical energy. However, the invention can be applied from any quantity whatever measured by a measuring system, as long as sum reading of the meters to be calibrated in the system is measured using a single collection meter, which should form an accurate sum of the quantities of the aforementioned several meters. In an electricity network, this is implemented by placing the collection meter on a conductor that represents the sum current of the sub-meters (e.g., field meters). In the case of water meters or district-heating meters, the collection meter should, on the other hand, measure the flow or energy of the main pipe, behind which the lower-level meters, such as field meters, are located.

The method can also be implemented locally in each collection meter, with the aid of software.

According to the invention, the transfer path and its changes between the collection meter 4 and the meters 1 beneath it can be taken in account by measuring the voltage in each meter and collecting the voltage data in the memory of the system. If the voltage difference between the collection meter 4 and a lower-level meter 1 changes at a constant current, it will be known that the properties of the transfer path have changed, due, for example, to a change in temperature or error state. Correspondingly, the properties of the transfer path can be estimated by simultaneously measuring the ratio of the power travelling through each meter to the voltage, whereby a change in the ration will indicate a change in the properties of the transfer path.

The manner of measurement referred to above can be used both to improve the accuracy of measurement and also to detect network faults.

**Claims**

1.  Method for calibrating meters in a system, in which several meters (1, *j*) are used to measure a desired quantity, one collection meter (4) being used to measure the quantity that forms the sum of the quantities of the aforesaid several meters (1), wherein

    - the measurement results of both the several meters (1) and of the collection meter (4) are recorded repeatedly and at least approximately simultaneously,
    - from the recorded measurement data and their times of recording, a model of the relative measurement error of the individual meters (1,j) and possibly of the deviation of the error, is created by matrix-calculation methods,
    - the collection meter (4) is of a precision class that is clearly more accurate than that of the meters (1), and the measurement results read from the meters are transmitted with the aid of a data network (7) to a server for calculation operations.

2.  Method according to Claim 1, wherein the energy consumption is measured.

**3.** Method according to Claim 3, wherein the electrical energy consumption is measured.

**4.** Method according to Claim 1, wherein the water consumption is measured.

**5.** Method according to Claim 1, wherein the model is created locally in the collection meter (4).

**6.** Method according to Claim 1, wherein the model in created centrally in the server (5) of a data network.

**7.** System for calibrating meters, in which system several meters (1, $j$) are arranged to measure a desired quantity, and one collection meter (4) is arranged to measure the quantity that forms the sum of the quantities of the aforesaid several meters (1), wherein

- the system comprises means for recording the measurement results of both the several meters (1) and of the collection meter (4) repeatedly and at least approximately simultaneously,
- the system comprises calculation means (5) for creating, from the recorded measurement data and their times of recording, a model of the relative measurement error of the individual meters (1, j) and possibly of the deviation of the error, by matrix-calculation methods, and
- the collection meter (4) is of a precision class that is clearly more accurate than that of the meters (1), the system being configured such that measurement results read from the meters are transmitted with the aid of a data network (7) to a server for calculation operations.

**8.** System according to Claim 7, wherein the meters (1, 4) are arranged to measure energy consumption.

**9.** System according to Claim 7, wherein the meters (1, 4) are arranged to measure electrical energy consumption.

**10.** System according to Claim 7, wherein the meters (1, 4) are arranged to measure water consumption.

**11.** System according to Claim 7, wherein the calculation means (5) are located in the collection meters (4).

**12.** System according to Claim 7, wherein the calculation means (5) are centralized in a data network (7).

**13.** A computer program configured to cause a method in accordance with at least one of claims 1-6 to be performed.

**Patentansprüche**

**1.** Verfahren zur Kalibrierung von Zählern in einem System, in welchem mehrere Zähler (1, j) verwendet werden, um eine gewünschte Menge zu messen, wobei ein Sammelzähler (4) benutzt wird, um die Menge zu messen, welche die Summe der Mengen der vorgenannten mehreren Zähler (1) bildet, wobei

- die Messergebnisse von sowohl den mehreren Zählern (1) und dem Sammelzähler (4) wiederholt und wenigstens ungefähr gleichzeitig aufgezeichnet werden,
- von den aufgezeichneten Messdaten und ihren Aufzeichnungszeiten wird ein Modell des relativen Messfehlers der individuellen Zähler (1, j) und möglicherweise der Abweichung des Fehlers durch Matrixberechnungsverfahren erzeugt,
- der Sammelzähler (4) ist von einer Genauigkeitsklasse, die eindeutig genauer ist als die der Zähler (1) und die von den Zählern abgelesenen Messergebnisse werden mittels eines Datennetzwerkes (7) für Rechenoperationen an einen Server übermittelt.

**2.** Verfahren nach Anspruch 1, wobei der Energieverbrauch gemessen wird.

**3.** Verfahren nach Anspruch 3, wobei der elektrische Energieverbrauch gemessen wird.

**4.** Verfahren nach Anspruch 1, wobei der Wasserverbrauch gemessen wird.

**5.** Verfahren nach Anspruch 1, wobei das Modell lokal in dem Sammelzähler (4) erzeugt wird.

**6.** Verfahren nach Anspruch 1, wobei das Modell zentral in dem Server (5) eines Datennetzwerkes erzeugt wird.

**7.** System zur Kalibrierung von Zählern, in welchem mehrere Zähler (1, j) dazu eingerichtet sind, um eine gewünschte Menge zu messen, wobei ein Sammelzähler (4) dazu eingerichtet ist, um die Menge zu messen, welche die Summe der Mengen der vorgenannten mehreren Zähler (1) bildet, wobei

    - das System Mittel umfasst, um die Messergebnisse von sowohl den mehreren Zählern (1) als auch dem Sammelzähler (4) wiederholt und wenigstens ungefähr gleichzeitig aufzuzeichnen,
    - das System Berechnungsmittel (5) umfasst, um von den aufgezeichneten Messdaten und ihren Aufzeichnungszeiten ein Modell des relativen Messfehlers der individuellen Zähler (1, j) und möglicherweise der Abweichung des Fehlers durch Matrixberechnungsverfahren zu erzeugen, und
    - der Sammelzähler (4) von einer Genauigkeitsklasse ist, die eindeutig genauer ist als die der Zähler (1), wobei das System so eingerichtet ist, dass die von den Zählern abgelesenen Messergebnisse mittels eines Datennetzwerkes (7) für Rechenoperationen an einen Server übermittelt werden.

**8.** System nach Anspruch 7, wobei die Zähler (1,4) dazu eingerichtet sind, um Energieverbrauch zu messen.

**9.** System nach Anspruch 7, wobei die Zähler (1,4) dazu eingerichtet sind, um elektrischen Energieverbrauch zu messen.

**10.** das System nach Anspruch 7, wobei die Zähler (1,4) dazu eingerichtet sind, um Wasserverbrauch zu messen.

**11.** System nach Anspruch 7, wobei sich die Berechnungsmittel (5) in dem Sammelzähler (4) befinden.

**12.** System nach Anspruch 7, wobei die Berechnungsmittel (5) in einem Datennetzwerk (7) zentralisiert sind.

**13.** Computerprogramm das dazu eingerichtet ist, um zu bewirken, dass ein Verfahren gemäß von wenigstens einem der Ansprüche 1-6 ausgeführt wird.

**Revendications**

**1.** Procédé d'étalonnage de compteurs dans un système, dans lequel plusieurs compteurs (1, j) sont utilisés pour mesurer une quantité désirée, un compteur de collecte (4) étant utilisé pour mesurer la quantité qui forme la somme des quantités des plusieurs compteurs (1) précités,
dans lequel

    - les résultats de mesure à la fois des plusieurs compteurs (1) et du compteur de collecte (4) sont enregistrés de façon répétée et au moins approximativement simultanément,
    - à partir des données de mesure enregistrées et de leurs temps d'enregistrement, un modèle de l'erreur relative de mesure des compteurs individuels (1, j) et possiblement de l'écart de l'erreur, est créé par des méthodes de calcul matriciel,
    - le compteur de collecte (4) est d'une classe de précision qui est clairement plus précise que celle des compteurs (1), et les résultats de mesure lus à partir des compteurs sont transmis à l'aide d'un réseau de données (7) vers un serveur pour les opérations de calcul.

**2.** Procédé selon la revendication 1, dans lequel la consommation d'énergie est mesurée.

**3.** Procédé selon la revendication 3, dans lequel la consommation d'énergie électrique est mesurée.

**4.** Procédé selon la revendication 1, dans lequel la consommation d'eau est mesurée.

**5.** Procédé selon la revendication 1, dans lequel le modèle est créé localement dans le compteur de collecte (4).

**6.** Procédé selon la revendication 1, dans lequel le modèle est créé de manière centrale dans le serveur (5) d'un réseau de données.

**7.** Système d'étalonnage de compteurs, dans lequel système plusieurs compteurs (1, j) sont arrangés pour mesurer une quantité désirée, et un compteur de collecte (4) est arrangé pour mesurer la quantité qui forme la somme des quantités des plusieurs capteurs (1) précités,

dans lequel

- le système comprend des moyens pour enregistrer les résultats de mesure à la fois des plusieurs compteurs (1) et du compteur de collecte (4) de façon répétée et au moins approximativement simultanément,
- le système comprend des moyens de calcul (5) pour créer, à partir des données de mesure enregistrées et de leurs temps d'enregistrement, un modèle de l'erreur relative de mesure des compteurs individuels (1, j) et possiblement de l'écart de l'erreur, par des méthodes de calcul matriciel
- le compteur de collecte (4) est d'une classe de précision qui est clairement plus précise que celle des compteurs (1), le système étant configuré de sorte que les résultats de mesure lus à partir des compteurs sont transmis à l'aide d'un réseau de données (7) vers un serveur pour des opérations de calcul.

8. Système selon la revendication 7, dans lequel les compteurs (1, 4) sont arrangés pour mesurer la consommation d'énergie.

9. Système selon la revendication 7, dans lequel les compteurs (1, 4) sont arrangés pour mesurer la consommation d'énergie électrique.

10. Système selon la revendication 7, dans lequel les compteurs (1, 4) sont arrangés pour mesurer la consommation d'eau.

11. Système selon la revendication 7, dans lequel les moyens de calcul (5) sont localisés dans les compteurs de collecte (4).

12. Système selon la revendication 7, dans lequel les moyens de calcul (5) sont centralisés dans un réseau de données (7).

13. Programme d'ordinateur configuré pour conduire un procédé selon au moins l'une des revendications 1 à 6 à être exécuté.

Collection meter    Meter j

_1_

_4_    _1_

7

Wired or wireless data network

_5_

Local wired
or wireless
data network

_1_

High voltage line    Low voltage line

Block of flats, factory,
shopping centre
etc

_1_

| Transfor-mer | | |

_6_    Transfor-mer _2_    _3_    _4_    _1_

_1_

# Fig. 1

_4_

**EP 1 955 088 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- DE 3743064 A1